# EUROPEAN PATENT SPECIFICATION

(11) **EP 4 462 464 B1**
(45) Date of publication and mention of the grant of the patent: **06.05.2026**
(21) Application number: 23172887.4
(22) Date of filing: 11.05.2023
(51) Int. Cl.: H01H 47/00, G01R 31/00, G01R 31/327

(54) **COMPUTER SYSTEM, VEHICLE, COMPUTER-IMPLEMENTED METHOD, COMPUTER PROGRAM PRODUCT AND COMPUTER-READABLE STORAGE MEDIUM FOR CONTACTOR DEVICE IDENTIFICATION**
COMPUTERSYSTEM, FAHRZEUG, COMPUTERIMPLEMENTIERTES VERFAHREN, COMPUTERPROGRAMMPRODUKT UND COMPUTERVERSTÄNDLICHES SPEICHERMEDIUM ZUR IDENTIFIZIERUNG EINER SCHÜTZVORRICHTUNG
SYSTÈME INFORMATIQUE, VÉHICULE, PROCÉDÉ MIS EN OEUVRE PAR ORDINATEUR, PROGRAMME D'ORDINATEUR ET SUPPORT DE STOCKAGE LISIBLE PAR ORDINATEUR POUR L'IDENTIFICATION D'UN DISPOSITIF CONTACTEUR

(43) Date of publication of application: 13.11.2024
(73) Proprietor: VOLVO TRUCK CORPORATION, 405 08 Göteborg (SE)
(72) Inventor: LIDSTRÖM, Emil, 423 56 Torslanda (SE); RAY, Dripta, 412 76 Göteborg (SE)
(74) Representative: Ström & Gulliksson AB

(56) References cited:
- WO-A1-2006/077279
- WO-A1-2021/056101
- US-A1- 2010 250 194

## Description

### TECHNICAL FIELD

The disclosure relates to identification of battery vehicle contactor device types. The disclosure can be applied to heavy-duty vehicles, such as trucks, buses, and construction equipment, among other vehicle types. Although the disclosure may be described with respect to a particular vehicle, the disclosure is not restricted to any particular vehicle.

### BACKGROUND

Contactors device are arranged for switching control circuits on or off, and may be arranged in electrical devices. Such electrical devices include, for instance, charging systems, steering systems, motor systems, fuel systems, air conditioning systems, and other components. In the following disclosure, a contactor device is to be interpreted as an element capable of altering the flow of electricity in a circuit by a switching mechanism. To this end, a contactor device as used herein refers to contactors, switches or relays, etc.

The number of contactor devices are continuously increasing. Given the sheer amount of contactor devices arranged in today's devices, there is a significant risk of said contactor devices being tampered with once they are out on the aftermarket. For example, vehicle workshops and other third parties are seeing great potential in providing counterfeit vehicle contactor devices by replacing, changing and/or to some extent modifying the existing vehicle contactor devices for their own winnings. In the example of vehicles, counterfeiting of vehicle contactor devices can lead to devastating losses, as the vehicle may continue to operate under unsafe operating conditions, according to the vehicle manufacturer's safety and regulatory standards, without the driver necessarily knowing about it. Such losses involve safety hazards for the driver and anyone being in the vicinity of the vehicle. Moreover, the performance of various electrical devices may be degraded as said vehicle contactor devices are no longer recognizable. It is therefore desired to identify the type of battery contactor devices.

### SUMMARY

According to a first aspect of the disclosure, a computer system comprising processing circuitry is provided. The processing circuitry is configured to provide a control signal to a vehicle contactor device control circuit comprising a battery contactor. The contactor device control circuit is configured to carry out a state switch in response to receiving said control signal and to receive a control signal response from the contactor device control circuit in response to said state switch. The processing circuitry is further configured to obtain one or more contactor device properties based on the control signal response to the control signal and to compare the one or more contactor device properties to baseline contactor device properties. The baseline contactor device properties are indicative of one or more predefined contactor device types. The processing circuitry is further configured to, based on said comparison, identify whether a type of said battery contactor corresponds to said one or more predefined contactor device types. A technical benefit may include safe vehicle operating conditions and an increased performance of electrical devices of the vehicle.

The processing circuitry is further configured to obtain the one or more contactor device properties by time series analysis on time series data included in the control signal response.

The processing circuitry is further configured to compare the one or more contactor device properties to the baseline contactor device properties by creating a response signature of the one or more contactor device properties based on the time series analysis; creating a baseline signature of baseline time series data included in the baseline contactor device properties; and comparing said response signature to the baseline signature. A technical benefit may include a more accurate type identification.

Optionally in some examples, including in at least one preferred example, the processing circuitry is further configured to create the baseline signature based on an output from a contactor device model being configured to process baseline contactor device properties of a plurality of said one or more predefined contactor device types. A technical benefit may include a more accurate type identification.

Optionally in some examples, including in at least one preferred example, the processing circuitry is further configured to compare the response signature to the baseline signature by identifying deviations exceeding a predefined threshold value. A technical benefit may include being able to adjust the hit rate of the comparison against a threshold value such that more adaptability can be achieved in the comparison.

Optionally in some examples, including in at least one preferred example, the processing circuitry is further configured to provide an identification report in response to said identification of whether a type of said contactor corresponds to one or more predefined contactor device types being performed. A technical benefit may include being able to compile the results of the type identification for further assessment thereof, for instance by a remote server at a workshop.

Optionally in some examples, including in at least one preferred example, the time series data pertain to a time-to-close duration of a closing operation of the contactor, said time-to-close duration being initiated upon said control signal being provided, said time-to-close duration ending upon completing the state switch, wherein the processing circuitry is further configured to determine the one or more contactor device properties as a function of a measured property of the control signal response in relation to a predefined property of the control signal during said closing operation. A technical benefit may include greater control and adaptability of how the identification is to be performed because the closing operation having the time-to-close duration is controllable and the input can accordingly be modelled in relation thereto.

Optionally in some examples, including in at least one preferred example, wherein the time series data pertain to a time-to-open duration of an opening operation of the contactor or a time-to-close duration of a closing operation of the contactor, said time-to-close or time-to-open duration being initiated upon said control signal being provided, said time-to-close or time-to-open duration ending upon completing the state switch, wherein the processing circuitry is further configured to control the opening operation or closing operation by pulse-width modulating the control signal. A technical benefit may include increasing the testing flexibility of various properties of the contactor device control circuit such that the identification procedure may become more accurate.

Optionally in some examples, including in at least one preferred example, the one or more contactor device properties are electrical properties and/or physical properties of the contactor. A technical benefit may include having a plurality of properties that can be compared to one another for increasing the identification accuracy.

Optionally in some examples, including in at least one preferred example, the time series data is obtained by one or more sensor units. A technical benefit may include being able to utilize existing sensors of the vehicle to identify the contactor device type which may involve a cheaper and less complex system.

The contactor is a battery contactor. A technical benefit may include being able to identify specific battery contactor devices.

According to a second aspect of the disclosure, a vehicle comprising the computer system of the first aspect is provided. The second aspect of the disclosure may seek to identify the type of a battery contactor device. A technical benefit may include safe vehicle operating conditions and an increased performance of electrical devices of the vehicle since they may be able to correctly assess contactors of the vehicle as the type thereof may behave as expected of said type of contactor device.

According to a third aspect of the disclosure, a computer-implemented method for battery contactor device identification is provided. The method comprises providing, by processing circuitry of a computer system, a control signal to a contactor device control circuit comprising a contactor, the contactor device control circuit being configured to carry out a state switch in response to receiving said control signal; receiving, by the processing circuitry, a control signal response from the contactor device control circuit in response to said state switch being carried out; obtaining, by the processing circuitry, one or more contactor device properties based on the control signal response to the control signal; comparing, by the processing circuitry, the one or more contactor device properties to baseline contactor device properties, the baseline contactor device properties being indicative of one or more predefined contactor device types; and based on said comparison, identifying, by the processing circuitry, whether a type of said battery contactor corresponds to said one or more predefined contactor device types. The third aspect of the disclosure may seek to identify the type of a vehicle contactor device. A technical benefit may include safe vehicle operating conditions and an increased performance of electrical devices of the vehicle since they may be able to correctly assess contactors of the vehicle as the type thereof may behave as expected of said type of contactor device.

According to a fourth aspect of the disclosure, a computer program product is provided. The computer program product comprises program code for performing, when executed by the processing circuitry, the method of the third aspect. The fourth aspect of the disclosure may seek to identify the type of a battery contactor device. A technical benefit may include safe vehicle operating conditions and an increased performance of electrical devices of the vehicle since they may be able to correctly assess contactors of the vehicle as the type thereof may behave as expected of said type of contactor device.

According to a fifth aspect of the disclosure, a non-transitory computer-readable storage medium is provided. The non-transitory computer-readable storage medium comprises program code for performing, when executed by the processing circuitry, the method of the third aspect. The fifth aspect of the disclosure may seek to identify the type of a battery contactor device. A technical benefit may include safe vehicle operating conditions and an increased performance of electrical devices of the vehicle since they may be able to correctly assess contactors of the vehicle as the type thereof may behave as expected of said type of contactor device.

Additional features and advantages are disclosed in the following description, claims, and drawings, and in part will be readily apparent therefrom to those skilled in the art or recognized by practicing the disclosure as described herein.

There are also disclosed herein computer systems, control units, code modules, computer-implemented methods, computer readable media, and computer program products associated with the above discussed technical benefits.

### BRIEF DESCRIPTION OF THE DRAWINGS

Examples are described in more detail below with reference to the appended drawings.
**FIG. 1** is an exemplary system diagram of a heavy-duty vehicle according to one example.
**FIG. 2** is an exemplary schematic block diagram visualizing data being used by the heavy-duty vehicle for battery contactor type identification according to one example.
**FIG. 3** is an exemplary schematic block diagram visualizing exemplary contactor device properties.
**FIG. 4** is an exemplary schematic block diagram visualizing battery contactor type identification based on signatures according to one example.
**FIG. 5** is an exemplary illustration visualizing signature deviations according to one example.
**FIGS. 6A-B**illustrate an exemplary contactor device model and exemplary data used by said contactor device model according to one example.
**FIG. 7** is an exemplary schematic flowchart illustration of a method according to one example.
**FIG. 8** is a schematic diagram of a computer system for implementing examples disclosed herein according to one example.

### DETAILED DESCRIPTION

The detailed description set forth below provides information and examples of the disclosed technology with sufficient detail to enable those skilled in the art to practice the disclosure.

As indicated in the above Background section, in prior art vehicles there are significant risks of contactor devices being tampered with once the vehicles are out on the aftermarket. The present disclosure provides an insightful approach of identifying a type of the contactor device by obtaining one or more contactor device properties and comparing them to baseline contactor device properties being indicative one or more predefined contactor device types. Various deviations exhibited in the data of the contactor device properties can be compared to the baseline contactor device properties, the baseline contactor device properties serving as reference to how the contactor device control circuit outputting a control signal response from which the contactor device properties were obtained is expected to be behaving. By identifying anomalies, it can, for example, be established what type of contactor device the contactor comprised in the contactor device control circuit is associated with. By knowing what type said contactor device is associated with, it can be assessed if there are potential counterfeit contactor devices being arranged in the vehicle during its time on the aftermarket. To this end, safe operating conditions can be assured according to the vehicle manufacturer's safety and regulatory standards.

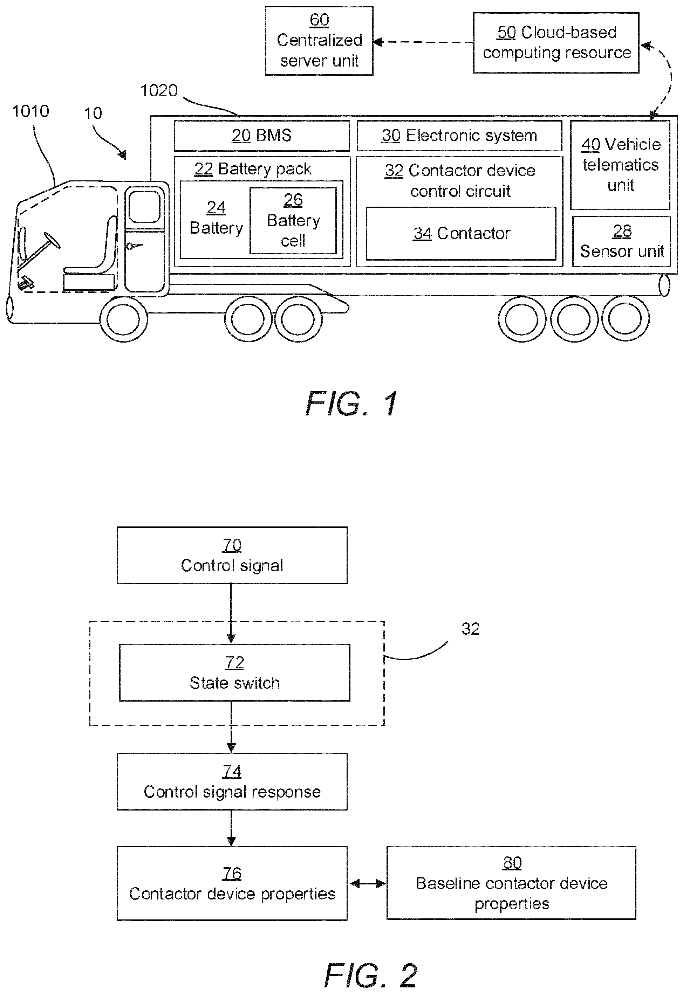

**FIG. 1** is an exemplary schematic illustration of a heavy-duty vehicle **10** (hereinafter referred to vehicle **10** for reasons of brevity). This particular vehicle **10** comprises a tractor unit **1010** which is arranged to tow a trailer unit **1020.** In other examples, other heavy-duty vehicles may be employed, e.g., trucks, buses, and construction equipment. Although not explicitly visualized in the figure, the skilled person will appreciate that the vehicle **10** comprises all necessary vehicle units and associated functionality such that it may operate as the skilled person would expect of a vehicle **10.** Emphasis in the present disclosure is instead directed at contactor device identification, as will now be discussed.

The vehicle **10** comprises a battery management system (BMS) **20.** The BMS **20** is configured to carry out a wide range of functionalities associated with at least one battery pack **22** of the vehicle **10.** Such wide range of functionalities may vary depending on the type of vehicle **10** and its operating conditions, but generally includes one or more of battery monitoring, battery protection, battery operational state estimation, battery performance optimization and battery operation status reporting. These actions are carried out with respect to the battery pack **22.**

The battery pack **22** is arranged in the vehicle **10** and adapted to power electrical devices (not shown) of the vehicle **10,** such as charging systems, steering systems, motor systems, fuel systems, air conditioning systems, and other vehicle components. Each battery pack **22** comprises at least one battery **24.** Each battery **24** comprises one or more battery cells **26.** Each battery cell **26** comprises a single anode and cathode separated by electrolyte that is used to provide a voltage and current. The BMS **20** may be configured to monitor the one or more battery cells **26.** Different types of batteries **24** comprise various numbers of battery cells **26.** Moreover, the battery cells **26** may be of different types for different types of batteries **24.** By way of example, a lithium-ion battery may comprise three cells to provide an 11.1 V battery, four cells to provide a 14.8 V battery, or 10 cells to provide a 37 V battery. Hence, the number and/or type of battery cells **26** may determine the amount of voltage and current being produced, which is consequently being monitored by the BMS **20.** In some examples, other types of battery cells **26** making up other batteries **24** may be realized, such as lead-acid batteries or nickel-metal hydride batteries. The functionalities explained above associated with the BMS **20** may be applied to either the entirety of the at least one battery pack **22,** portions thereof (e.g., one or more individual batteries **24),** or even individual battery cells **26.** The present disclosure is not limited to any number or types of battery packs **22,** batteries **24** or battery cells **26.**

The vehicle **10** comprises a contactor device control circuit **32.** As described in the Background section, the contactor device control circuit **32** may be a circuit of a contactor, relay or switch and being arranged in any of the electrical devices as discussed above, for instance in the battery pack **22** or batteries **24** thereof. The contactor device control circuit **32** comprises a contactor **34.** The contactor **34** is a switching element capable of adjusting the control signals transferred through said contactor device control circuit **32.** In this example, the contactor **34** is a battery contactor. The battery contactor **34** may be a high-voltage contactor or high-voltage relay. The battery contactor **34** is configured to carry out state switches in response to signals flowing through the contactor device control circuit **32.** Although not shown in **FIG. 1****,** the contactor device control circuit **32** may include other components as well, such as fuses, circuit breakers and sensors configured to ensure a safe operation of the contactor device control circuit **32.** The battery contactor **34** may be an electromechanical switch configured to respectively engage and disengage a metal plate, such as a copper plate, to and from the leads of a high-voltage current path of the contactor device control circuit **32,** thereby mechanically operating an electric contact. The electromechanical switch may comprise a solenoid, i.e., a cylindrical coil of wire, and a plunger rod. The plunger rod is made of a material inherently capable of resisting permanent magnetization, such as copper or aluminum. Electrical signals passing through the solenoid creates a magnetic field that attracts the plunger rod. The metal plate is attached to the plunger such that the engagement/disengagement of the plate to and from the current path of the contactor device control circuit **32** is enabled. The electromechanical switch may be a relay.

A contactor device control circuit **32** may be connected to battery cells **26.** The battery cells **26** may be a stack of battery cells **26.** The stack of battery cells **26** corresponds to a series of individual battery cells **26** being stacked together to create a higher voltage throughput (e.g., two 12 V batteries stacked together may output 24 V). The battery contactor **34** of the contactor device control circuit **32** may be respectively engaged and disengaged to and from the stack of battery cells **26.** The battery contactor **34** may thus be configured to connect or disconnect the entire stack of battery cells **26** to or from an electrical machine.

The vehicle **10** comprises an electronic system **30.** The electronic system **30** may be embedded in one or more of the battery packs **22** or associated batteries **24.** Alternatively, the electronic system **30** may be partly embedded in the one or more battery packs **22** or associated batteries, and partly comprised in a cloud-based computing resource **50.** Yet alternatively, the electronic system may be entirely comprised in the cloud-based computing system **50,** with associated interfaces to collect data from and provide data to the contactor device control circuit **32.** The electronic system **30** comprises processing circuitry being configured to control contactors of the vehicle **10,** i.e., one or more contactor device control circuits **32** having respective battery contactors **34.** The electronic system **30** is configured to provide one or more control signals to the contactor device control circuit **32** for controlling the contactor device control circuit **32** to carry out a state switch. To this end, the control signal may be a CLOSE or OPEN signal (0 or 1), indicating that the contactor device control circuit **32** is to carry out a closing operation or an opening operation. Once the state switch is carried out, the contactor device control circuit **32** generates a control signal response which is received by the processing circuitry of the electronic system **30.** Since one particular contactor device control circuit **32** may be different from another one with respect to various electrical or physical properties, the control signal response exhibits different behaviors. In order to establish the different behaviors, one or more sensor units **28** may be utilized.

The vehicle **10** advantageously comprises at least one sensor unit **28.** The sensor unit **28** is arranged to provide measurements of the contactor device control circuit **32.** A single sensor unit **28** may be configured to provide measurements from one or more contactor device control circuits **32.** Alternatively, one sensor unit **28** may be arranged and configured in operation with a respective contactor device control circuit **32.** To this end, the vehicle **10** may comprise a plurality of sensor units **28,** each sensor unit **28** being arranged at a respective contactor device control circuit **32.**

The sensor unit **28** may be any type of sensor capable of measuring data associated with the control signal response. The sensor unit **28** may be of different sensor types, including but not limited to voltage sensors, current sensors, temperature sensors, electrochemical sensors, State of Charge (SoC) sensors, State of Health (SoH) sensors, gas sensors, pressure sensors, humidity sensors, accelerometers, optical sensors, magnetic sensors, or ultrasonic sensors. The sensor unit **28** may be configured as a combination of one or more of these various sensor types. Different sensor units **28** may be realized as one or more of these mentioned sensor types.

The processing circuitry of the electronic system **30** is configured to obtain one or more contactor device properties based on the control signal response to the control signal. "Based on" shall in this context be interpreted as the properties being obtained from the control signal response (output) to a corresponding control signal (input). This may be done by analyzing the data measured by the sensor unit(s) **28.** The processing circuitry is configured to compare the contactor device properties to baseline contactor device properties which are indicative of one or more predefined contactor device types. Once the comparison has been carried out, the processing circuitry is configured to identify whether a type of the contactor device control circuit **32** matches or to some extent corresponds to one particular type from among the one or more predefined contactor device types. Accordingly, the processing circuitry may carry out vehicle contactor device identification.

Even a minor difference in one or more physical and/or electrical properties of a first contactor device type can distinguish it from a second contactor device type, even if they are of the same type. Such minor difference may be related to preferences different manufacturers put on their contactor device type, e.g., dimensions, sizes, signal outputs, and so forth, but may also pertain to the functionality of the contactor device control circuit. By way of example, a first BMS contactor manufactured by an original equipment manufacturer (OEM) can, on the face of it, appear similar to a second BMS contactor that has been manufactured by a third party not being said OEM. To this end, the minor difference(s) exhibited by the physical and/or electrical properties of the BMS contactors may be identified thanks to the concepts defined by the present disclosure relating to vehicle contactor device identification.

The vehicle **10** advantageously comprises a vehicle telematics unit **40.** The vehicle telematics unit **40** is configured for obtaining data from the vehicle **10,** such as from the electronic system **30** or the BMS **20,** and communicate said data wirelessly to an external service. The identification results may be transmitted by the vehicle telematics unit **40** to a cloud-based computing resource **50** during an ongoing operation of the vehicle **10,** i.e., in online mode. Alternatively, or additionally, control signal responses may be sent as raw data to the cloud-based computing resource **50,** and subsequent obtaining, comparing and identifying of the type of contactor may be performed by the cloud-based computing resource **50.** To this end, the contactor type identification may be carried out remote from the vehicle **10.** In some examples, the cloud-based computing resource **50** may receive control signal responses from a vehicle fleet comprising a plurality of vehicles and carry out the identification procedure based on information received from said vehicle fleet. The identification results may be transmitted as an identification report in response to the identification of whether a type of said contactor device control unit **32** corresponds to a type of the one or more predefined contactor device types being performed. The operation of the vehicle **10** may be a particular usage of the vehicle **10,** such as a start-up at a first location, a drive to a second location, and a shutdown at said second location. Such online data transmission may be realized in at least near real-time, where at least near real-time is to be interpreted as involving some minor delay caused by, for instance, network connectivity, latencies, or other similar reasons. In some examples, batch processing and transfer of the data may be realized. In this particular example, the vehicle telematics unit **40** is configured to be in communication with a cloud-based computing resource **50.** The communication may be based on any known short-range or long-range standards or protocols known in the art. The following list of examples are some exemplary network/radio communication standards or protocols that may be employed by the vehicle telematics unit **40** and the cloud-based computing resource **50:** HTTP(S), TCP/IP, UDP, FTP, SMTP, DNS, DHCP, SSH, POP3, SCP, NFS, SFTP, ICMP, ARP, RTP, RTCP IEEE 802.11, IEEE 802.15, ZigBee, WirelessHART, WiFi, Bluetooth^{®}, BLE, RFID, WLAN, MQTT IoT, CoAP, DDS, NFC, AMQP, LoRaWAN, Z-Wave, Sigfox, Thread, EnOcean, mesh communication, any form of proximity-based device-to-device radio communication, LTE Direct, W-CDMA/HSPA, GSM, UTRAN, LTE, IPv4, IPv6, 6LoWPAN, IrDA, or 5G NR.

The cloud-based computing resource **50** may be implemented using any commonly known cloud-computing platform technologies, such as e.g. Amazon Web Services, Google Cloud Platform, Microsoft Azure, DigitalOcean, Oracle Cloud Infrastructure, IBM Bluemix or Alibaba Cloud. The cloud-based computing resource **50** may be included in a distributed cloud network that is widely and publically available, or alternatively limited to an enterprise. The cloud-based computing resource **50** may comprise a cloud-based storage unit. The cloud-based storage unit may be included with or external to the cloud-based computing resource **50.** Connection to the cloud-based storage unit may be established using DBaaS (Database-as-a-service). For instance, the cloud-based storage unit may be deployed as a SQL data model such as MySQL, PostgreSQL or Oracle RDBMS. Alternatively, deployments based on NoSQL data models such as MongoDB, Amazon DynamoDB, Hadoop or Apache Cassandra may be used. DBaaS technologies are typically included as a service in the associated cloud-based computing resource **50.**

The cloud-based computing resource **50** may be in further communication with a centralized server unit **60.** Communication between the cloud-based computing resource **50** and the centralized server unit **60** may be realized by any of the communication standards or protocols as mentioned above with respect to the cloud-based computing resource **50** and the vehicle telematics unit **40.** The centralized server unit **60** may be configured for collecting and analyzing data from a plurality of vehicles, and subsequently provide new and/or updated data to said plurality of vehicles based on various factors such as new contactor device types or characteristics.

In some examples, the identification results are not necessarily transferred from the vehicle telematics unit **40** to the centralized server unit **60** during an ongoing operation of the vehicle **10.** Instead, the identification results may be transferred in an offline fashion after the vehicle **10** has finished an operation. Hence, the vehicle telematics unit **40** is configured to store the identification results during the operation, but the transfer is not effected until after said operation is completed. This may be realized in certain situations, such as at vehicle workshops or other vehicle maintenance locations.

**FIG. 2** is an exemplary schematic block diagram visualizing data being used by the vehicle **10** for contactor device identification. The data flow is initiated by the provision of a control signal **70** to a contactor device control circuit **32.** In response to receiving the control signal **70,** the contactor device control circuit **32** is configured to carry out a state switch **72.** Once the state switch **72** is carried out, the contactor device control circuit **32** accordingly generates a control signal response **74,** and or more contactor device properties **76** are obtained based on the control signal response **74** to the control signal.

The state switch **72** may be a closing operation of the contactor **34.** The closing operation pertain to a time-to-close duration which is initiated upon the control signal **70** being provided, and ends upon the closing operation state switch **72** being completed, for instance as achieved upon the metal plate disengaging the high-voltage current path of the contactor device control circuit **32.** Where the state switch **72** is a closing operation, the contactor device properties **76** may be determined as a function of a measured property, such as current or voltage, of the control signal response **74** in relation to a predefined property, such as current or voltage, of the control signal **70.** A time-curve may accordingly be generated of said function, which depend on physical and/or electrical properties of the contactor **34,** such as dimensions of internal parts thereof (e.g., solenoid, plunger rod, fuse, breaker, and so forth). For example, during the closing operation, the voltage and/or current of the contactor device control circuit **32** controlling the solenoid will, as a function of time, have a shape that depends on the movement of the plunger and the time it takes for the plunger to complete the movement. Two different contactors having different plungers or solenoid are therefore expected to exhibit different behaviors of voltage and/or current as respective functions of time.

In alternative examples, the state switch **72** may be either one of a closing operation or an opening operation. Similar to the closing operation, the opening operation pertain to a time-to-open duration that is realized the same way, i.e., the time between the provisioning of the control signal **70** until the opening operation state switch **72** being completed. For said alternative examples where the state switch **72** is either one of a closing operation or an opening operation, the control signal **70** may be controlled by pulse width modulation (PWM). By adjusting the width of the pulses of the control signal **70,** the average voltage or current provided by the control signal response **74** can be controlled. This may increase the testing flexibility of various properties of the contactor device control circuit **32** such that the identification procedure may become more accurate. Pulse frequency modulation (PFM) is another method that may be realized for state switches **72** being either one of a closing operation or an opening operation. Finally, the obtained contactor device properties **76** are compared to baseline contactor device properties **80.**

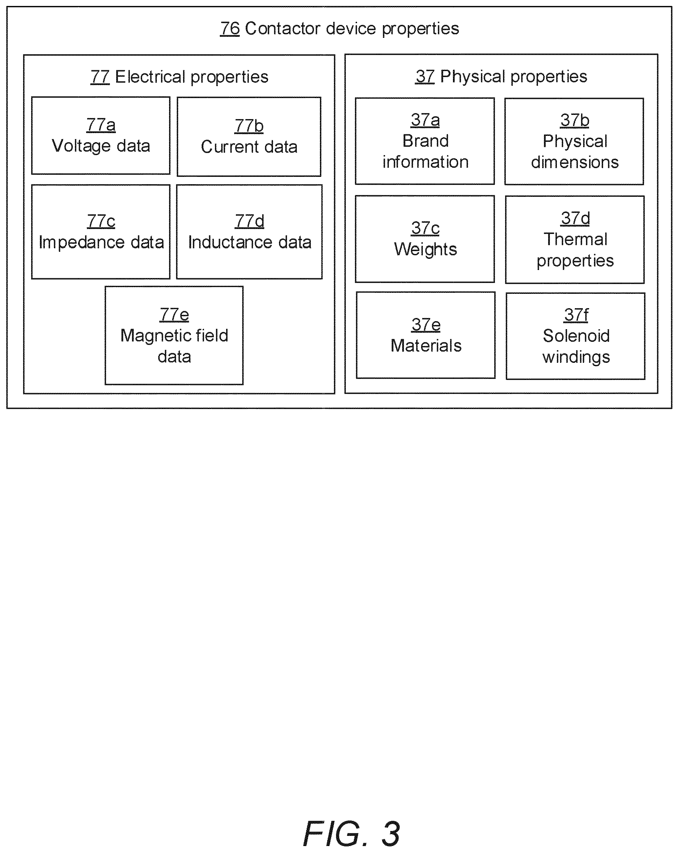

**FIG. 3** shows exemplary contactor device properties **76.** As discussed above, the processing circuitry of the electronic system **30** may be configured to obtain one or more contactor device properties **76** including electrical properties **77** and/or physical properties **37** of contactors. The electrical properties **77** and the physical properties **37** may be related to one another. For example, variations in voltage or current in the contactor device control circuit affects the physical components such as the solenoid and the metal plate associated therewith. The properties **37, 77** shown in **FIG. 3** may include any additional or fewer properties than those shown. The electrical properties **77** include voltage data **77a,** current data **77b,** impedance data **77c,** inductance data **77d,** and magnetic field data **77e.** The physical properties **37** include brand information **37a,** physical dimensions **37b** and weights **37c** of components of the contactor device, thermal properties **37d,** materials **37e** and solenoid windings **37f.** Some of the properties, such as the voltage data **77a** and the current data **77b,** may be obtained directly by measuring the voltage and current of the control signal response, for instance by the sensor units as discussed above. Other properties, such as the physical dimensions **37b** of internal components of the contactor device may, for example, be obtained from an appearance of the resulting voltage over time function in relation to the provided control signal **70.**

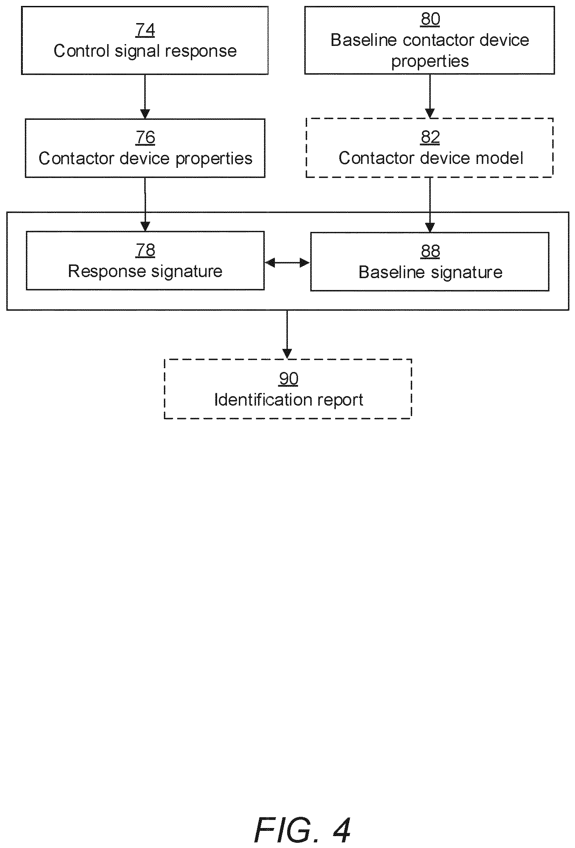

One or more of the contactor device properties **76** may indicate variations in contactor device types that can be identified by comparing said contactor device properties **76** to corresponding baseline contactor device properties **80.** One such exemplary comparison approach will now be explained with reference to **FIG. 4****.**

In **FIG. 4****,** one example of providing an identification report **90** of vehicle contactor device identification results is shown. The identification is based on time series analysis. More specifically, one or more contactor device properties **76** are obtained by time series analysis on time series data included in the control signal response **74.** Since the control signal response **74** pertain to various durations of closing and/or opening operations of state switches of the contactor, these durations are in this example being analyzed using time series analysis.

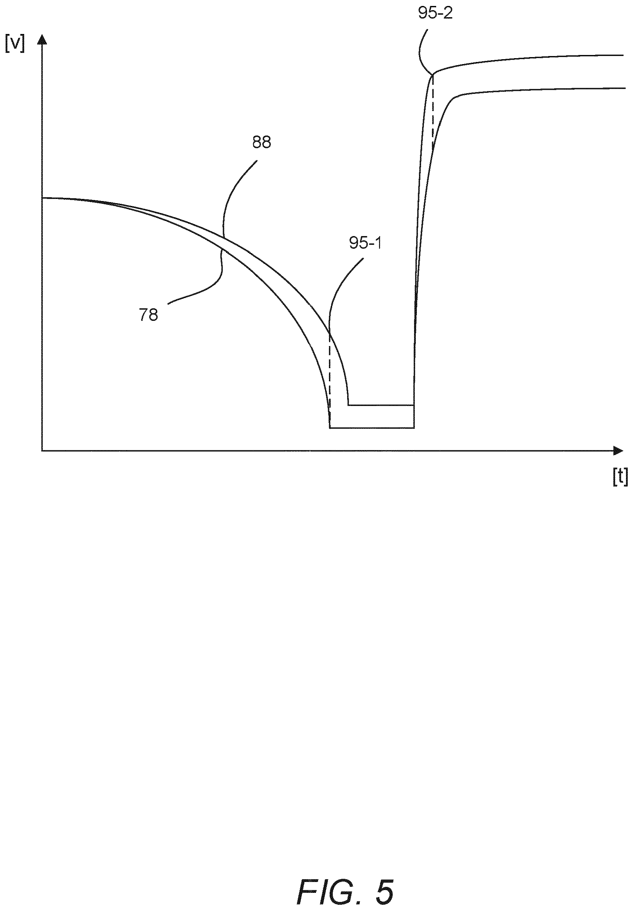

The comparison between the contactor device properties **76** and the baseline contactor device properties **80** may be carried out with respect to corresponding signatures thereof, said signatures being created based on respective time series data. The term "signature" can alternatively be interpreted as a fingerprint, identifier, or other such terms that define various characteristics of properties over time. A response signature **78** is created of the one or more contactor device properties **76** based on the time series analysis. Moreover, a baseline signature **88** of baseline time series data included in the baseline contactor device properties **80** is created. The baseline signature **88** thus serves as a reference to how the contactor device control circuit outputting the control signal response **74** from which the contactor device properties **76** are obtained is expected to be behaving. By identifying anomalies, it can be established what type of contactor device the contactor of the contactor device control circuit is associated with. The respective signatures **78, 88** are then compared to one another for providing the identification results in the form of the identification report **90.** The features of the signatures **78, 88** depend on what properties **76, 80** they are based upon. To this end, if the signatures **78, 88** are created as a function of voltage over time of a closing or opening state switch, the respective voltage functions are compared to one another over time. This is shown according to one example in **FIG. 5****.**

**FIG. 5** shows an exemplary approach of comparing the response signature **78** to the baseline signature **88.** In this particular example, the signatures **78, 88** are respectively created by analyzing voltage [v] time series data over time [t], although alternative variations are clearly possible. As indicated in the illustration, the signatures **78, 88** differ slightly. However, at two particular points in time, **95-1** and **95-2,** signatures **78, 88** differ to an extent such that the deviations exceed a predefined threshold value (not shown in **FIG. 5****).** This may be an indication that the control signal response **74** outputted by the contactor device control circuit **32** does not correlate to an expected control signal response as determined by the baseline signature **88** serving as a reference behavior of the expected response signature **78.** The deviations indicated by the times **95-1, 95-2** may thus indicate that the type of the contactor does not correlate to the baseline type thereof. This may by extension indicate that the contactor has been tampered with (e.g., replaced or modified) during the vehicle's time at the aftermarket.

With further reference to **FIG. 4****,** the identification report **90** may in some examples be based on a plurality of determined and compared signatures. Adding further conditions to determine a deviation may increase the accuracy of the identification procedure. By way of example, the voltage time series analysis as depicted in **FIG. 5** may be complemented with a corresponding impedance data time series analysis, and potential deviations may require both of the analyses to respectively exceed a predefined threshold value in order to establish a potential deviating type. Alternatively, one of the time series analyses may be associated with a predefined threshold value that differ from the predefined threshold value of the other time series analysis depending on operating conditions. Any such additional and/or alternative considerations may be taken into account depending on the circumstances surrounding the identification of the type of the contactor.

The baseline signature **88** may be created by the approach as discussed above, namely based on baseline time series data of said one or more predefined contactor device types. This approach may be suitable when it is desired to directly compare the response signature **78** to a (known) selected type of baseline signature **88** where a match is expected. This may be the case where it is desired to confirm whether a particular contactor is the same type that was originally arranged in the vehicle.

Another approach is based on employing a contactor device model **82.** Using this approach, the baseline signature **88** is instead based on an output from the contactor device model **82** being configured to process baseline contactor device properties **80** of a plurality of said one or more predefined contactor device types. Hence, this approach may be suitable when it is desired to find out what type, from among a plurality of baseline contactor device types, the contactor corresponds to.

The contactor device model **82** may be, at least partly, implemented by the cloud-based computing resource **40** as discussed with reference to **FIG. 1****,** for instance using any of the above-mentioned cloud-computing technologies. Alternatively, the contactor device model **82** may be implemented by in-vehicle electronics, such as an internal vehicle controller or other microprocessor unit. The contactor device model **82** is configured to obtain the baseline signature **88** by employing data processing techniques.

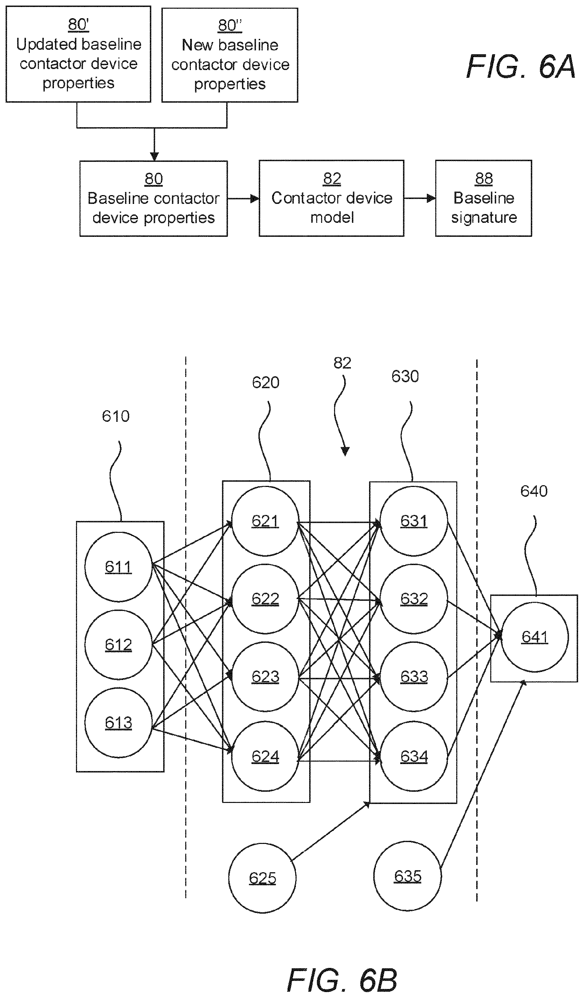

**FIG. 6A-B**show an exemplary contactor device model **82** and associated data used by the model **82** to output the baseline signature **88.** The contactor device model **82** is in this example a neural network which is configured to employ machine learning approaches. The neural network is configured to continuously receive input data. The input data comprises baseline contactor device properties **80** being provided with updated baseline contactor device properties **80**' as well as new baseline contactor device properties **80".** The updated baseline contactor device properties **80'** correspond to new updates in already stored types of reference contactor device types. The new baseline contactor device properties **80"** correspond to contactor device types that have not yet been encountered by the neural network. The neural network is configured to perform a training procedure by processing the continuously received input data. The neural network is configured to output the baseline signature **88** taking into account the training procedure. A request for identification of a type of contactor may involve finding a suitable match of the response signature thereof with an output from the contactor device model **82.** The trained neural network is capable of providing an intelligent identification of contactor device types based on previous identifications of contactor device types. During use, the neural network may be configured to mark correct and/or incorrect identifications to further take into account when performing additional identification procedures so as to learn from previous behavior, ultimately improving its accuracy. To this end, the neural network comprises self-learning features. Although being a neural network in this particular example, the contactor device model **82** may alternatively employ other supervised or unsupervised learning algorithms known in the art, such as binary, multi-class, or multi-label classification and/or clustering algorithms. For instance, algorithms such as logistic regression, support vector machines, kernel estimation, decision trees and/or neural networks may be utilized.

The contactor device model **82** being a neural network is shown according to one example in **FIG. 6B****.** The neural network is exemplified as having an input layer **610,** two hidden layers **620, 630,** and an output layer **640.** The input layer **610** comprises three nodes **611, 612, 613,** the first hidden layer **620** comprises four nodes **621, 622, 623, 624,** the second hidden layer **630** comprises four nodes **631, 632, 633, 634** and the output layer **640** comprises one node **641.** Moreover, the neural network comprises two weight nodes **625, 635,** each being associated with a respective hidden layer **620, 630.** The skilled person appreciates that this is just an exemplary neural network that can be implemented as the contactor device model **82.** Other networks may include any suitable number of input nodes, any suitable number of hidden layers and associated hidden nodes, any suitable number of output nodes, and any suitable number of weight nodes. The neural network may implement backpropagation for training purposes such that its performance of identifying contactor device types may be improved. The input nodes **611, 612, 613** may receive the input data as discussed above. The output node **641** may output the baseline signature **88** as a result of the processing of the input data by the hidden layers **620, 630** and associated weight nodes **625, 635.**

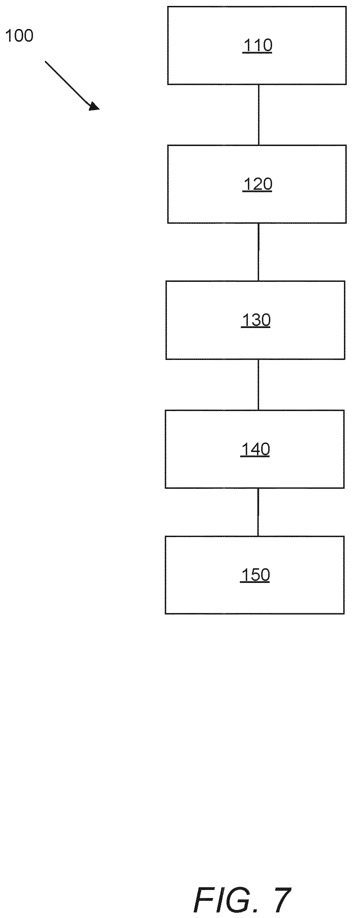

**FIG. 7** is a flowchart of a method **100** for vehicle contactor device identification. The method **100** comprises providing **110,** by processing circuitry of a computer system, a control signal to a contactor device control circuit comprising a contactor, the contactor device control circuit being configured to carry out a state switch in response to receiving said control signal. The method **100** comprises receiving **120,** by the processing circuitry, a control signal response from the contactor device control circuit in response to said state switch being carried out. The method **100** comprises obtaining **130,** by the processing circuitry, one or more contactor device properties based on the control signal response to the control signal. The method **100** comprises comparing **140,** by the processing circuitry, the one or more contactor device properties to baseline contactor device properties, the baseline contactor device properties being indicative of one or more predefined contactor device types. The method **100** comprises, based on said comparison, identifying **150,** by the processing circuitry, whether a type of said battery contactor corresponds to said one or more predefined contactor device types.

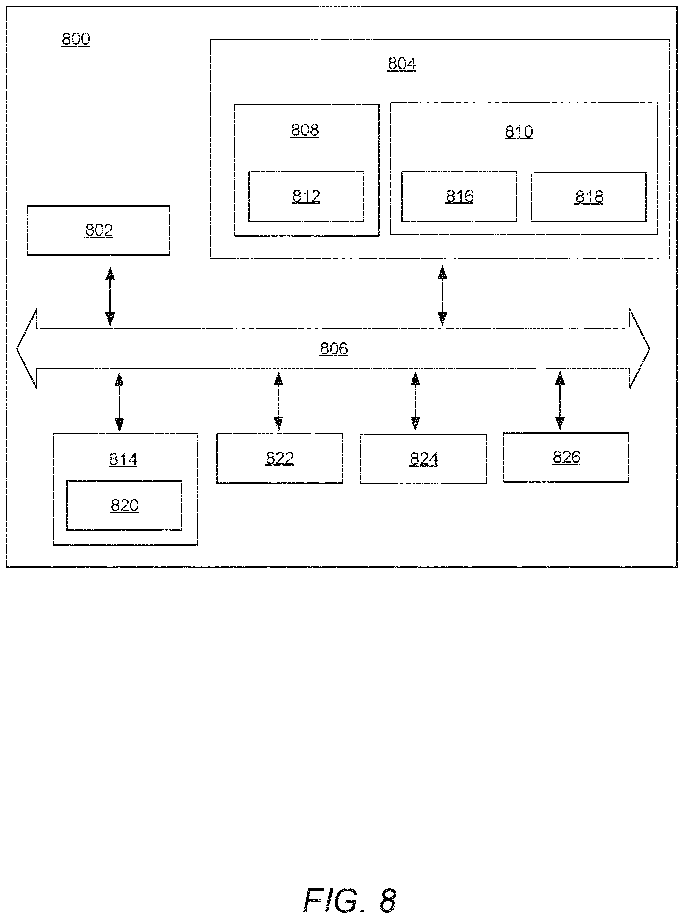

**FIG. 8** is a schematic diagram of a computer system **800** for implementing examples disclosed herein. The computer system **800** is adapted to execute instructions from a computer-readable medium to perform these and/or any of the functions or processing described herein. The computer system **800** may be connected (e.g., networked) to other machines in a LAN, an intranet, an extranet, or the Internet. While only a single device is illustrated, the computer system **800** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **800** may comprise at least one computing device or electronic device capable of including firmware, hardware, and/or executing software instructions to implement the functionality described herein. The computer system **800** may include processing circuitry **802** (e.g., processing circuitry including one or more processor devices or control units), a memory **804,** and a system bus **806.** The computer system **800** may include at least one computing device having the processing circuitry **802.** The system bus **806** provides an interface for system components including, but not limited to, the memory **804** and the processing circuitry **802.** The processing circuitry **802** may include any number of hardware components for conducting data or signal processing or for executing computer code stored in memory **804.** The processing circuitry **802** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **802** may further include computer executable code that controls operation of the programmable device.

The system bus **806** may be any of several types of bus structures that may further interconnect to a memory bus (with or without a memory controller), a peripheral bus, and/or a local bus using any of a variety of bus architectures. The memory **804** may be one or more devices for storing data and/or computer code for completing or facilitating methods described herein. The memory **804** may include database components, object code components, script components, or other types of information structure for supporting the various activities herein. Any distributed or local memory device may be utilized with the systems and methods of this description. The memory **804** may be communicably connected to the processing circuitry **802** (e.g., via a circuit or any other wired, wireless, or network connection) and may include computer code for executing one or more processes described herein. The memory **804** may include non-volatile memory **808** (e.g., read-only memory (ROM), erasable programmable read-only memory (EPROM), electrically erasable programmable read-only memory (EEPROM), etc.), and volatile memory **810** (e.g., randomaccess memory (RAM)), or any other medium which can be used to carry or store desired program code in the form of machine-executable instructions or data structures and which can be accessed by a computer or other machine with processing circuitry **802.** A basic input/output system (BIOS) **812** may be stored in the non-volatile memory **808** and can include the basic routines that help to transfer information between elements within the computer system **800.**

The computer system **800** may further include or be coupled to a non-transitory computer-readable storage medium such as the storage device **814,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **814** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **814** and/or in the volatile memory **810,** which may include an operating system **816** and/or one or more program modules **818.** All or a portion of the examples disclosed herein may be implemented as a computer program **820** stored on a transitory or non-transitory computer-usable or computer-readable storage medium (e.g., single medium or multiple media), such as the storage device **814,** which includes complex programming instructions (e.g., complex computer-readable program code) to cause the processing circuitry **802** to carry out actions described herein. Thus, the computer-readable program code of the computer program **820** can comprise software instructions for implementing the functionality of the examples described herein when executed by the processing circuitry **802.** In some examples, the storage device **814** may be a computer program product (e.g., readable storage medium) storing the computer program **820** thereon, where at least a portion of a computer program **820** may be loadable (e.g., into a processor) for implementing the functionality of the examples described herein when executed by the processing circuitry **802.** The processing circuitry **802** may serve as a controller or control system for the computer system **800** that is to implement the functionality described herein.

The computer system **800** may include an input device interface **822** configured to receive input and selections to be communicated to the computer system **800** when executing instructions, such as from a keyboard, mouse, touch-sensitive surface, etc. Such input devices may be connected to the processing circuitry **802** through the input device interface **822** coupled to the system bus **806** but can be connected through other interfaces, such as a parallel port, an Institute of Electrical and Electronic Engineers (IEEE) 1394 serial port, a Universal Serial Bus (USB) port, an IR interface, and the like. The computer system **800** may include an output device interface **824** configured to forward output, such as to a display, a video display unit (e.g., a liquid crystal display (LCD) or a cathode ray tube (CRT)). The computer system **800** may include a communications interface **826** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software. In addition, two or more actions may be performed concurrently or with partial concurrence.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. In the drawings and specification, there have been disclosed aspects for purposes of illustration only and not for purposes of limitation, the scope of the disclosure being set forth in the following claims.

## Claims

1. A computer system comprising processing circuitry configured to:
provide a control signal (70) to a vehicle contactor device control circuit (32) comprising a battery contactor (34), the vehicle contactor device control circuit (32) being configured to carry out a state switch (72) in response to receiving said control signal (70);
receive a control signal response (74) from the vehicle contactor device control circuit (32) in response to said state switch (72);
obtain one or more contactor device properties (76) based on the control signal response (74) to the control signal (70) by performing time series analysis on time series data included in the control signal response (74);
compare the one or more contactor device properties (76) to baseline contactor device properties (80), being indicative of one or more predefined contactor device types, by:
creating a response signature (78) of the one or more contactor device properties (76) based on the time series analysis;
creating a baseline signature (88) of baseline time series data included in the baseline contactor device properties (80); and
comparing said response signature (78) to the baseline signature (88), and
based on said comparison, identify whether a type of said battery contactor (34) corresponds to said one or more predefined contactor device types.

2. The computer system of claim 1, wherein the processing circuitry is further configured to create the baseline signature (88) based on an output from a contactor device model (82) being configured to process baseline contactor device properties (80) of a plurality of said one or more predefined contactor device types.

3. The computer system of claim 1 or 2, wherein the processing circuitry is further configured to compare the response signature (78) to the baseline signature (88) by identifying deviations exceeding a predefined threshold value.

4. The computer system of any of claim 1-3, wherein the processing circuitry is further configured to provide an identification report (90) in response to said identification of whether a type of said contactor (34) corresponds to one or more predefined contactor device types being performed.

5. The computer system of any of the claims 1-4, wherein the time series data pertain to a time-to-close duration of a closing operation of the contactor (34), said time-to-close duration being initiated upon said control signal input (70) being provided and said time-to-close duration ending upon completing the state switch (72),
wherein the processing circuitry is further configured to determine the one or more contactor device properties (76) as a function of a measured property of the control signal response (74) in relation to a predefined property of the control signal (70) during said closing operation.

6. The computer system of any of the claims 1-4, wherein the time series data pertain to a time-to-open duration of an opening operation of the contactor (34) or a time-to-close duration of a closing operation of the contactor (34), said time-to-close or time-to-open duration being initiated upon said control signal (70) being provided, said time-to-close or time-to-open duration ending upon completing the state switch (72),
wherein the processing circuitry is further configured to pulse-width modulate the control signal (70).

7. The computer system of any preceding claim, wherein the one or more contactor device properties (76) are electrical properties (77) and/or physical properties (37) of the contactor (34).

8. The computer system of any of the claims 1-7, wherein the time series data is obtained by one or more sensor units (28).

9. A vehicle comprising the computer system of any of claims 1-8.

10. A computer-implemented method (100) for vehicle contactor device identification, comprising:
providing (110), by processing circuitry of a computer system, a control signal (70) to a vehicle contactor device control circuit (32) comprising a battery contactor (34), the vehicle contactor device control circuit (32) being configured to carry out a state switch (72) in response to receiving said control signal (70);
receiving (120), by the processing circuitry, a control signal response (74) from the vehicle contactor device control circuit (32) in response to said state switch (72);
obtaining (130), by the processing circuitry, one or more contactor device properties (76) based on the control signal response (74) to the control signal (70) by performing time series analysis on time series data included in the control signal response (74);
comparing (140), by the processing circuitry, the one or more contactor device properties (76) to baseline contactor device properties (80), being indicative of one or more predefined contactor device types, by:
creating a response signature (78) of the one or more contactor device properties (76) based on the time series analysis;
creating a baseline signature (88) of baseline time series data included in the baseline contactor device properties (80); and
comparing said response signature (78) to the baseline signature (88) and based on said comparison, identifying (150), by the processing circuitry, whether a type of said battery contactor (34) corresponds to said one or more predefined contactor device types.

11. A computer program product comprising program code for performing, when executed by the processing circuitry, the method (100) of claim 10.

12. A non-transitory computer-readable storage medium comprising instructions, which when executed by the processing circuitry, cause the processing circuitry to perform the method (100) of claim 10.

## Patentansprüche

1. Computersystem, umfassend Verarbeitungsschaltung, die zu Folgendem konfiguriert ist:
Bereitstellen eines Steuersignals (70) für eine Fahrzeugschützvorrichtung-Steuerschaltung (32), umfassend ein Batterieschütz (34), wobei die Fahrzeugschützvorrichtung-Steuerschaltung (32) konfiguriert ist, um als Reaktion auf ein Empfangen des Steuersignals (70) eine Zustandsumschaltung (72) durchzuführen;
Empfangen einer Steuersignalantwort (74) von der Fahrzeugschützvorrichtung-Steuerschaltung (32) als Reaktion auf die Zustandsumschaltung (72);
Erlangen einer oder mehrerer Schützvorrichtungseigenschaften (76) basierend auf der Steuersignalantwort (74) auf das Steuersignal (70) durch Durchführen von Zeitreihenanalyse über Zeitreihendaten, die in der Steuersignalantwort (74) beinhaltet sind;
Vergleichen der einen oder der mehreren Schützvorrichtungseigenschaften (76) mit Schützvorrichtung-Basiseigenschaften (80), die indikativ für einen oder mehrere vordefinierte Schützvorrichtungstypen sind, durch:
Erzeugen einer Antwortsignatur (78) einer oder mehrerer Schützvorrichtungseigenschaften (76) basierend auf der Zeitreihenanalyse;
Erzeugen einer Basissignatur (88) von Basiszeitreihendaten, die in den Schützvorrichtung-Basiseigenschaften (80) beinhaltet sind; und
Vergleichen der Antwortsignatur (78) mit der Basissignatur (88), und
basierend auf dem Vergleich, Identifizieren, ob ein Typ des Batterieschützes (34) einem oder mehreren vordefinierten Schützvorrichtungstypen entspricht.

2. Computersystem nach Anspruch 1, wobei die Verarbeitungsschaltung ferner konfiguriert ist, um die Basissignatur (88) basierend auf einer Ausgabe von einem Schützvorrichtungsmodell (82) zu erzeugen, das konfiguriert ist, um Schützvorrichtung-Basiseigenschaften (80) einer Vielzahl des einen oder der mehreren vordefinierten Schützvorrichtungstypen zu verarbeiten.

3. Computersystem nach Anspruch 1 oder 2, wobei die Verarbeitungsschaltung ferner konfiguriert ist, um die Antwortsignatur (78) durch Identifizieren von Abweichungen, die einen vordefinierten Schwellenwert überschreiten, mit der Basissignatur (88) zu vergleichen.

4. Computersystem nach einem der Ansprüche 1 bis 3, wobei die Verarbeitungsschaltung ferner konfiguriert ist, um einen Identifizierungsbericht (90) als Reaktion darauf bereitzustellen, dass die Identifizierung, ob ein Typ des Schützes (34) einem oder mehreren vordefinierten Schütztypen entspricht durchgeführt wird.

5. Computersystem nach einem der Ansprüche 1 bis 4, wobei die Zeitreihendaten zu einer Schließdauer eines Schließvorgangs des Schützes (34) gehören, wobei die Schließdauer bei Bereitstellen des Steuersignaleingangs (70) beginnt und bei Abschluss der Zustandsumschaltung (72) endet,
wobei die Verarbeitungsschaltung ferner konfiguriert ist, um die eine oder die mehreren Schützvorrichtungseigenschaften (76) abhängig von einer gemessenen Eigenschaft der Steuersignalantwort (74) in Bezug auf eine vordefinierte Eigenschaft des Steuersignals (70) während des Schließvorgangs zu bestimmen.

6. Computersystem nach einem der Ansprüche 1-4, wobei die Zeitreihendaten zu einer Öffnungsdauer eines Öffnungsvorgangs des Schützes (34) oder einer Schließdauer eines Schließvorgangs des Schützes (34) gehören, wobei die Öffnungs- bzw. Schließdauer bei Bereitstellen des Steuersignals (70) beginnt und bei Abschluss der Zustandsumschaltung (72) beendet wird,
wobei die Verarbeitungsschaltung ferner konfiguriert ist, um das Steuersignal (70) zu pulsbreitenmodulieren.

7. Computersystem nach einem der vorherigen Ansprüche, wobei die eine oder die mehreren Schützvorrichtungseigenschaften (76) elektrische Eigenschaften (77) und/oder physikalische Eigenschaften (37) des Schützes (34) sind.

8. Computersystem nach einem der Ansprüche 1 bis 7, wobei die Zeitreihendaten durch eine oder mehrere Sensoreinheiten (28) erlangt werden.

9. Fahrzeug, umfassend das Computersystem nach einem der Ansprüche 1-8.

10. Computerimplementiertes Verfahren (100) zur Fahrzeugschützvorrichtung-Identifizierung, umfassend:
Bereitstellen (110), durch Verarbeitungsschaltung eines Computersystems, eines Steuersignals (70) für die Fahrzeugschützvorrichtung-Steuerschaltung (32) umfassend ein Batterieschütz (34), wobei die Fahrzeugschützvorrichtung-Steuerschaltung (32) konfiguriert ist, um als Reaktion auf ein Empfangen des Steuersignals (70) eine Zustandsumschaltung (72) durchzuführen;
Empfangen (120), durch die Verarbeitungsschaltung, einer Steuersignalantwort (74) von der Fahrzeugschützvorrichtung-Steuerschaltung (32) als Reaktion auf die Zustandsumschaltung (72);
Erlangen (130), durch die Verarbeitungsschaltung, einer oder mehrerer Schützvorrichtungseigenschaften (76) basierend auf der Steuersignalantwort (74) auf das Steuersignal (70) durch Durchführen von Zeitreihenanalyse über Zeitreihendaten, die in der Steuersignalantwort (74) beinhaltet sind;
Vergleichen (140) der einen oder der mehreren Schützvorrichtungseigenschaften (76) mit Schützvorrichtung-Basiseigenschaften (80), die indikativ für einen oder mehrere vordefinierte Schützvorrichtungstypen sind, durch:
Erzeugen einer Antwortsignatur (78) einer oder mehrerer Schützvorrichtungseigenschaften (76) basierend auf der Zeitreihenanalyse;
Erzeugen einer Basissignatur (88) von Basiszeitreihendaten, die in den Schützvorrichtung-Basiseigenschaften (80) beinhaltet sind; und
Vergleichen der Antwortsignatur (78) mit der Basissignatur (88) und basierend auf dem Vergleich, Identifizieren (150), durch die Verarbeitungsschaltung, ob ein Typ des Batterieschützes (34) einem oder mehreren vordefinierten Schützvorrichtungstypen entspricht.

11. Computerprogrammprodukt, umfassend Programmcode zum Durchführen des Verfahrens (100) von Anspruch 10, wenn er durch eine Verarbeitungsschaltung ausgeführt wird.

12. Nicht-transitorisches, computerlesbares Speichermedium, umfassend Anweisungen, die, wenn sie von der Verarbeitungsschaltung ausgeführt werden, die Verarbeitungsschaltung veranlassen, das Verfahren (100) von Anspruch 10 durchzuführen.

## Revendications

1. Système informatique comprenant un circuit de traitement configuré pour :
fournir un signal de commande (70) à un circuit de commande de dispositif contacteur de véhicule (32) comprenant un contacteur de batterie (34), le circuit de commande de dispositif contacteur de véhicule (32) étant configuré pour effectuer un changement d'état (72) en réponse à la réception dudit signal de commande (70) ;
recevoir une réponse de signal de commande (74) du circuit de commande de dispositif contacteur de véhicule (32) en réponse audit changement d'état (72) ;
obtenir une ou plusieurs propriétés de dispositif contacteur (76) sur la base de la réponse de signal de commande (74) au signal de commande (70) en effectuant une analyse de séries chronologiques sur des données de séries chronologiques incluses dans la réponse de signal de commande (74) ;
comparer les une ou plusieurs propriétés de dispositif contacteur (76) aux propriétés de dispositif contacteur de référence (80), indiquant un ou plusieurs types de dispositif contacteur prédéfinis, par :
la création d'une signature de réponse (78) des une ou plusieurs propriétés de dispositif contacteur (76) sur la base de l'analyse de séries chronologiques ;
la création d'une signature de référence (88) des données de séries chronologiques de référence incluses dans les propriétés de dispositif contacteur de référence (80) ; et
la comparaison de ladite signature de réponse (78) à la signature de référence (88), et
sur la base de ladite comparaison, l'identification si un type dudit contacteur de batterie (34) correspond auxdits un ou plusieurs types de dispositif contacteur prédéfinis.

2. Système informatique selon la revendication 1, dans lequel le circuit de traitement est en outre configuré pour créer la signature de référence (88) sur la base d'une sortie d'un modèle de dispositif contacteur (82) configuré pour traiter les propriétés de dispositif contacteur de référence (80) d'une pluralité desdits au moins un ou plusieurs types de dispositif contacteur prédéfinis.

3. Système informatique selon la revendication 1 ou 2, dans lequel le circuit de traitement est en outre configuré pour comparer la signature de réponse (78) à la signature de référence (88) en identifiant les écarts dépassant une valeur seuil prédéfinie.

4. Système informatique selon l'une quelconque des revendications 1 à 3, dans lequel le circuit de traitement est en outre configuré pour fournir un rapport d'identification (90) en réponse à la réalisation de ladite identification si un type dudit contacteur (34) correspond à un ou plusieurs types de dispositif contacteur prédéfinis.

5. Système informatique selon l'une quelconque des revendications 1 à 4, dans lequel les données de séries chronologiques se rapportent à une durée de fermeture d'une opération de fermeture du contacteur (34), ladite durée de fermeture étant démarrée lorsque ladite entrée de signal de commande (70) est fournie et ladite durée de fermeture se terminant lorsque le changement d'état (72) est terminé,
dans lequel le circuit de traitement est en outre configuré pour déterminer les une ou plusieurs propriétés de dispositif contacteur (76) en fonction d'une propriété mesurée de la réponse de signal de commande (74) par rapport à une propriété prédéfinie du signal de commande (70) pendant ladite opération de fermeture.

6. Système informatique selon l'une quelconque des revendications 1 à 4, dans lequel les données de séries chronologiques se rapportent à une durée d'ouverture d'une opération d'ouverture du contacteur (34) ou à une durée de fermeture d'une opération de fermeture du contacteur (34), ladite durée de fermeture ou d'ouverture étant démarrée lorsque ledit signal de commande (70) est fourni, ladite durée de fermeture ou d'ouverture se terminant lorsque le changement d'état (72) est terminé,
dans lequel le circuit de traitement est en outre configuré pour moduler la largeur d'impulsion du signal de commande (70).

7. Système informatique selon l'une quelconque des revendications précédentes, dans lequel les une ou plusieurs propriétés de dispositif contacteur (76) sont des propriétés électriques (77) et/ou des propriétés physiques (37) du contacteur (34).

8. Système informatique selon l'une quelconque des revendications 1 à 7, dans lequel les données de séries chronologiques sont obtenues par une ou plusieurs unités de détection (28).

9. Véhicule comprenant le système informatique selon l'une quelconque des revendications 1 à 8.

10. Procédé mis en œuvre par ordinateur (100) pour l'identification d'un dispositif contacteur de véhicule, comprenant :
la fourniture (110), par le circuit de traitement d'un système informatique, d'un signal de commande (70) à un circuit de commande de dispositif contacteur de véhicule (32) comprenant un contacteur de batterie (34), le circuit de commande de dispositif contacteur de véhicule (32) étant configuré pour effectuer un changement d'état (72) en réponse à la réception dudit signal de commande (70) ;
la réception (120), par le circuit de traitement, d'une réponse de signal de commande (74) du circuit de commande de dispositif contacteur de véhicule (32) en réponse audit changement d'état (72) ;
l'obtention (130), par le circuit de traitement, d'une ou plusieurs propriétés de dispositif contacteur (76) sur la base de la réponse de signal de commande (74) au signal de commande (70) en effectuant une analyse de séries chronologiques sur des données de séries chronologiques incluses dans la réponse de signal de commande (74) ;
la comparaison (140), par le circuit de traitement, des une ou plusieurs propriétés de dispositif contacteur (76) aux propriétés de dispositif contacteur de référence (80), indiquant un ou plusieurs types de dispositif contacteur prédéfinis, par :
la création d'une signature de réponse (78) des une ou plusieurs propriétés de dispositif contacteur (76) sur la base de l'analyse de séries chronologiques ;
la création d'une signature de référence (88) des données de séries chronologiques de référence incluses dans les propriétés de dispositif contacteur de référence (80) ; et
la comparaison de ladite signature de réponse (78) à la signature de référence (88) et, en fonction de ladite comparaison, l'identification (150), par le circuit de traitement, si un type dudit contacteur de batterie (34) correspond auxdits un ou plusieurs types de dispositif contacteur prédéfinis.

11. Produit de programme informatique comprenant un code de programme pour réaliser, lorsqu'il est exécuté par le circuit de traitement, le procédé (100) selon la revendication 10.

12. Support de stockage non transitoire lisible par ordinateur comprenant des instructions qui, lorsqu'elles sont exécutées par le circuit de traitement, amènent le circuit de traitement à réaliser le procédé (100) selon la revendication 10.
